# EUROPEAN PATENT SPECIFICATION

(11) **EP 1 310 028 B1**
(45) Date of publication and mention of the grant of the patent: **20.12.2006**
(21) Application number: 01974976.1
(22) Date of filing: 08.08.2001
(51) Int. Cl.: H02G 3/22, H05K 9/00

(54) **BUSHING ARRANGEMENT**
DURCHFÜHRUNGSEINRICHTUNG
GAINE

(30) Priority: 08.08.2000 NL 1015895
(43) Date of publication of application: 14.05.2003
(73) Proprietor: Beele Engineering B.V., 7122 NZ Aalten (NL)
(72) Inventor: BEELE, Johannes, Alfred, NL-7122 NZ AALTEN (NL)
(74) Representative: HOFFMANN EITLE
(86) International application number: PCT/NL2001/000594
(87) International publication number: WO 2002/013347

(56) References cited:
- WO-A-00/23513
- WO-A-99/45620
- FR-A- 2 657 471
- GB-A- 2 265 262

## Description

The invention relates to a bushing arrangement for passing at least one cable through an opening in a wall, plating, partition and the like (such as a bulkhead of a ship, for example) whilst providing protection against electromagnetic overtension and/or interference. Hereinafter, the term "wall" will be used for the sake of simplicity, whilst said term is understood to include other partitions as well.

Such a bushing arrangement is disclosed in Dutch patent application no. 1011718 in the name of the present applicant. The bushing arrangement that is disclosed therein consists of a steed bushing arrangement fitted in a wall opening, through which a number of single-core or multiple-core cables are passed. The cables are stripped of their sheathing along a suitable part of their length, so that said cables can locally come into electrically conductive contact with their environment. The aforesaid longitudinal parts of the cables are then embedded in an electrically conductive moulding paste so as to effect electrical conduction between said cables and said bushing arrangement, after which the wall opening is filled up with a suitable sealing compound. A rubber hose member may be fitted round each cable before the moulding paste is provided, whilst the remaining space in the wall opening will be filled with similar hose members in that case. One drawback of the bushing arrangement that is disclosed in the aforesaid Dutch patent application is the fact that it has become apparent in practice that in some cases the moulding paste exhibits a relatively high electrical resistance value, in the order of about 100 - 100 Ohm, after curing. In particular this means that the degree to which electricity can flow away to earth via the moulding paste has decreased considerably, which has an adverse effect on the extent of protection that is provided against electromagnetic overtension. The same applies, mutatis mutandis, as regards (the protection against) electromagnetic interference.

The object of the invention is to improve the bushing arrangement that is known from the prior art, in the sense that there is proposed a high-grade fire resistant, gastight and liquid-tight bushing arrangement which is furthermore optimally protected against electromagnetic overtension and/or interference.

In order to accomplish that objective, a bushing arrangement of the kind referred to in the introduction is characterized in that said bushing arrangement comprises an electrically conductive tape, which is in contact with an electrically conductive cable shielding of said at least one cable being passed through and which functions to earth said cable shielding, wherein said electrically conductive type is substantially made of an electrically conductive rubber being made electrically conductive through the addition thereto of carbon particles in the form of carbon black.

Electrical installations and machines, which usually include highly sensitive components, for example for control and registration purposes, can easily experience interference caused by various external electromagnetic fields and pulses. Said electromagnetic fields and pulses may have been generated by radar installations, thunderstorms, nuclear explosions and electrical equipment, for example. A measure that is frequently used in practice for reducing such interference is the provision of a steel structure, which functions as a Faraday cage, round the space that is intended for electronic equipment. Electrical cables that are passed into such a screened space can conduct undesirable electromagnetic fields and pulses into the electronic equipment yet, however. Said conduction will generally take place over the electrically conductive shielding (braid) of the respective cables that are passed through.

According to the invention, said external undesirable em fields and pulses will flow away to earth along the electrically conductive shielding of a cable being passed through, via the electrically conductive tape. In particular, said electrically conductive tape is at least partially wound round the electrically conductive cable shielding in the operative condition.

It is noted that within the framework of the invention the term "cable" is understood to include an electrically conductive conduit, tube, pipe of the like, for example a metallic tube or pipe, with the present tape being in electrically conductive contact therewith in the operative condition.

In one preferred embodiment of a bushing arrangement according to the invention, the electrically conductive tape.is wound round the electrically conductive cable shielding near its one end, whilst it is in electrically conductive contact with an electrically conductive bushing housing (made of a metal, for example) that is fitted in the opening in the wall. In another preferred embodiment, the earthing of the electrically conductive cable shielding is effected by means of said electrically conductive tape by providing an electrically conductive material on at least one open side of the wall, which material is in electrically conductive contact with the tape. Said electrically conductive material is at least substantially made up of several pieces of electrically conductive tape material, whether or not folded, which have been placed into said opening, and/or of several electrically conductive sleeve means or hose members which have been placed into said opening, which hose members or sleeve means preferably extend in the same direction as said at least one cable being passed through.

In another preferred variant, said electrically conductive material is the graphite-containing moulding paste that is known from the aforesaid Dutch patent application no. 1011718.

In another preferred embodiment of a bushing arrangement according to the invention, the electrically conductive sleeve means is substantially made of an electrically conductive rubber. Said rubber has been made electrically conductive in particular by chemical means, in particular through the addition thereto of carbon particles, preferably in the form of carbon black. In particular, said rubber is EPDM rubber, whilst said carbon particles are preferably concave shell-shaped, especially of the type "Ketjenblack EC" 300J or 600 JD ^{™}. These known types of carbon black known under the commercial name of "Ketjenblack" have a unique morphology in comparison with conventional types of carbon black, which renders them exceptionally suitable for the present electrically conductive application. The abbreviation EPDM stands for Ethylene/Propylene/Diene/Monomer. It is noted that also other elastomers or plastomers can be used as materials for said sleeve means.

Preferably, the electrically conductive tape is flexible, that is, deformable, so that it can readily be passed along other cables that are passed through the bushing arrangement.

In another preferred embodiment of a bushing arrangement according to the invention, the electrically conductive tape has a contact width of at least about 20 mm, preferably about 40 mm. In the latter case, the tape is usually used for civil applications (attenuation factor -30 dB), whilst a contact width of more than 100 mm (attenuation factor -60 dB) can be used for military applications. By winding the present tape of such width round the electrically conductive cable shielding, an optimum electrically conductive contact is effected so as to prevent electromagnetic overtension and/or interference.

In another preferred embodiment of a bushing arrangement according to the invention, the remaining space in the wall opening is at least partially filled up with several fire resistant sleeve means, which extend in the same direction as said at least one cable being passed through. Possibly, each cable is passed through one of said sleeve means thereby. The sleeve means or hose members are preferably divided lengthways, so that, in the latter case, they can be fitted over the cables after said cables have been pulled through the bushing arrangement.

In another preferred embodiment of a bushing arrangement according to the invention, a heat resistant and/or liquid repellent (preferably expandable) putty is sealingly provided on at least one open side of the opening. Said putty functions to enhance the gas tightness and liquid tightness of the present bushing arrangement.

The invention furthermore relates to a method for passing at least one cable through an opening in a wall and the like whilst providing protection against electromagnetic overtension and/or interference, using a bushing arrangement according to the invention, FR2657471 discloses a bushing arrangement for passing a cable (1) through an opening in a wall and the like whilst providing protection against electromagnetic overtension and/or interference. The bushing arrangement of FR2657471 comprises an electrically conductive element of generally rectangular cross-section formed into a spiral surrounding the cable so that, in use, two opposite sides of the rectangle abut against the corresponding sides of adjacent coils of the spiral, while one of the remaining sides contacts the exposed metallic sheath of the cable and the other contacts the inner wall of metallic bushing housing The conductive element is composed of a layer of metallic braiding embedded in an elastomeric body so that the braiding is exposed on the sides of the rectangle contacting the cable sheath and the bushing housing respectively. By this means the conductive element functions to earth said cable shielding

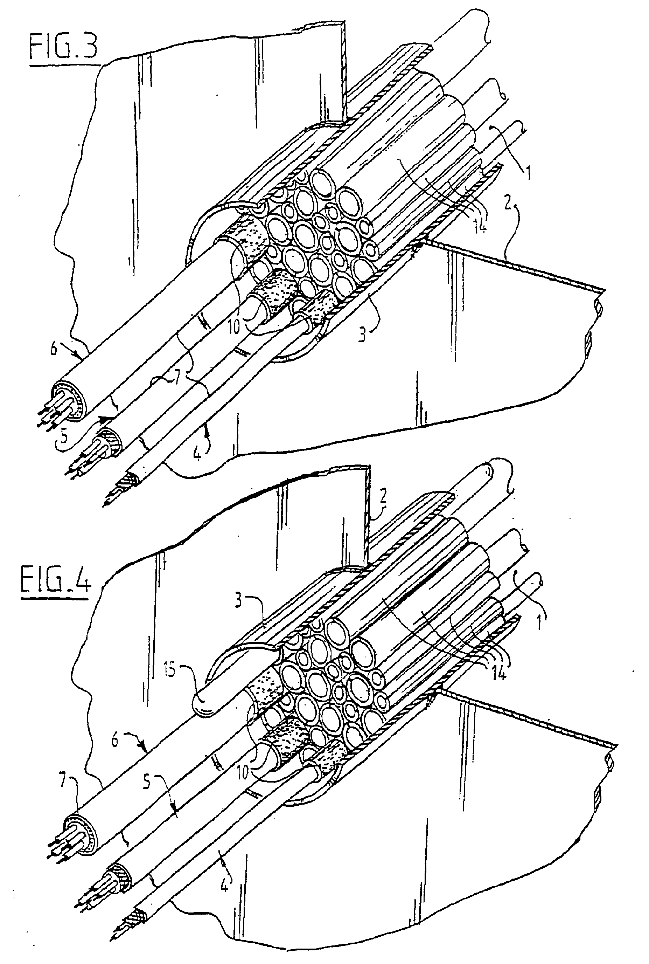

WO 0023513 discloses a material for providing both electromagnetic interference (EMI) shielding and fire resistance. The material is recommended for use as a jacket for a sealing gasket, as a cable wrap or a tape (see abstract). The material of WO 0023513 comprises an electrically conductive layer a backing layer of pressure-sensitive adhesive (PSA) and an optional reinforcing layer (Fig. 2). The PSA layer includes an admixture of expandable, intercalated graphite particles However, the purpose of these particles is to form an expanded carbonific char to form a thermally insulating protective barrier when exposed to fire. When used as a jacket for a gasket ,the purpose of the material is to provide an electrically conductive path between the two substrates (not shown), between which the gasket forms a seal. It is suggested on page 17 of D2 WO 0023513, inasmuch as the bulk conductivity of gasket is determined substantially through its surface contact with the substrate, **an electrically conductive PSA** may be preferred, to ensure optimal EMI shielding performance and that this conductivity may be achieved by the admixture of materials such as ... carbon and graphite. However, it is clear that the purpose of this measure in WO 0023513 is to improve the electrical conductivity parallel to the surface of the gasket (50). A mention in WO 0023513 of the possible use of the material as a tape or cable wrap is aimed at sheathing the cable with a continuous, conductive, shielding surface. WO 9945620 (from the present applicant) discloses a bushing arrangement providing protection against electromagnetic overtension and/or interference, which comprises a sealing collar of massive rubber, which has been made electrically conductive by the admixture of carbon black.

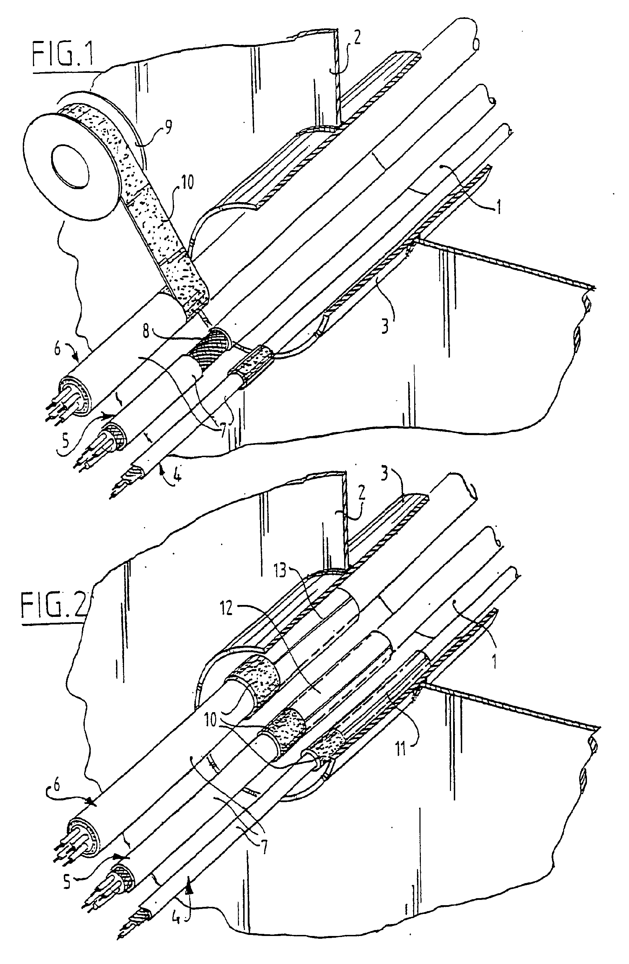

The invention will now be explained in more detail with reference to figures illustrated in a drawing, wherein Figures 1 - 8 are schematic, perspective views of various successive steps for providing a preferred variant of a high-grade fire resistant, gastight and liquid-tight bushing arrangement according to the invention, which is furthermore optimally protected against electromagnetic overtension and/or interference.

Figure 1 shows an opening in a wall 2, in which a steel bushing housing 3 is mounted. For the sake of simplicity, only three multi-core cables 4, 5, 6 are shown in the drawing, which cables have each been stripped of their plastic sheathing 7 along part of their length, so that their electrically conductive shielding (braid) 8 is now exposed. In accordance with the invention, a tape 10 of EPDM rubber on a winding roll 9 is used, which tape has been made electrically conductive by the chemical addition thereto of carbon particles (for example carbon black particles), which tape is to be wound round the electrically conductive cable shielding 8. Tape 10 preferably has a width of 40 mm, so that an optimum electrically conductive contact with said electrically conductive cable shielding 8 is realised. The electrical earthing is ensured by winding tape 10 to a diameter larger than that of cables 4, 5, 6, as is shown in Figure 1 and as will be explained in more detail yet.

Figure 2 shows the situation of Figure 1, with this understanding that a fire resistant (rubber) hose member 11, 12, 13 is fitted round each cable 4, 5, 6 and that the provision of the tape 10 has been concluded. The latter has been carried out by cutting tape 10 off the winding roll 9 and attaching the free end of tape 10 thus formed to the part of the tape 10 that has already been wound round the cable by heating said end. "Attachment" can also be effected by binding a band or the like round the wound tape 10. In Figure 3, the remaining space of the bushing housing 3 in the wall opening 1 is filled with fire resistant (rubber) hose members 14, which are identical to hose members 11, 12, 13. Hose members 14 function as fillers, therefore. A bar-shaped element 15 (which may or may not be made of an electrically conductive material) is inserted in one of the hose members 14, which is done in order to make it possible to pass a new cable through the bushing housing 3 instead of the bar-shaped element in due course, whereby the bar-shaped element 15 functions to determine the correct position for said new cable, therefore. Hose members 11, 12, 13, 14 are known under the trade name "RISE" of the present applicant.

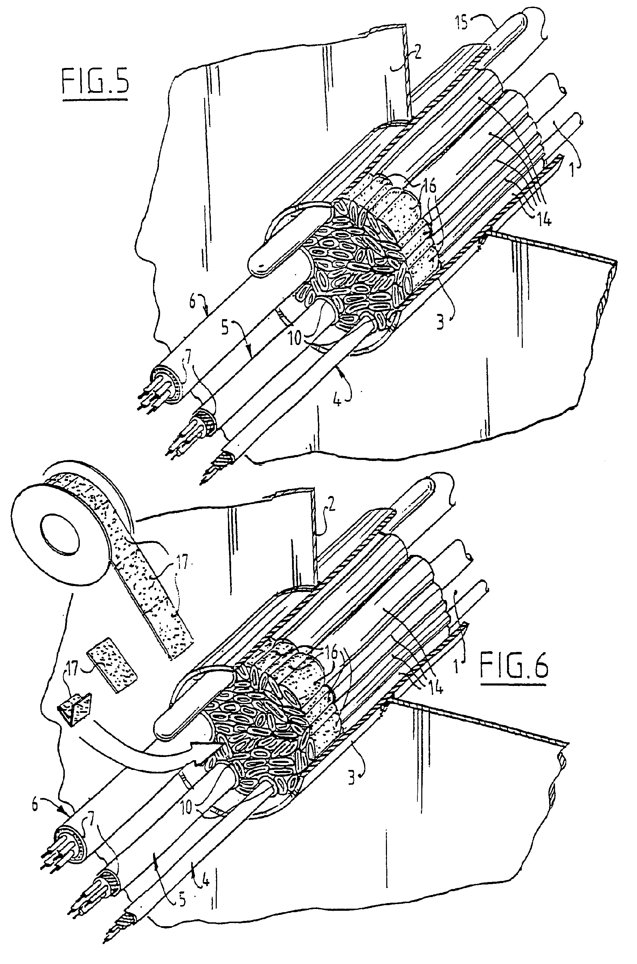

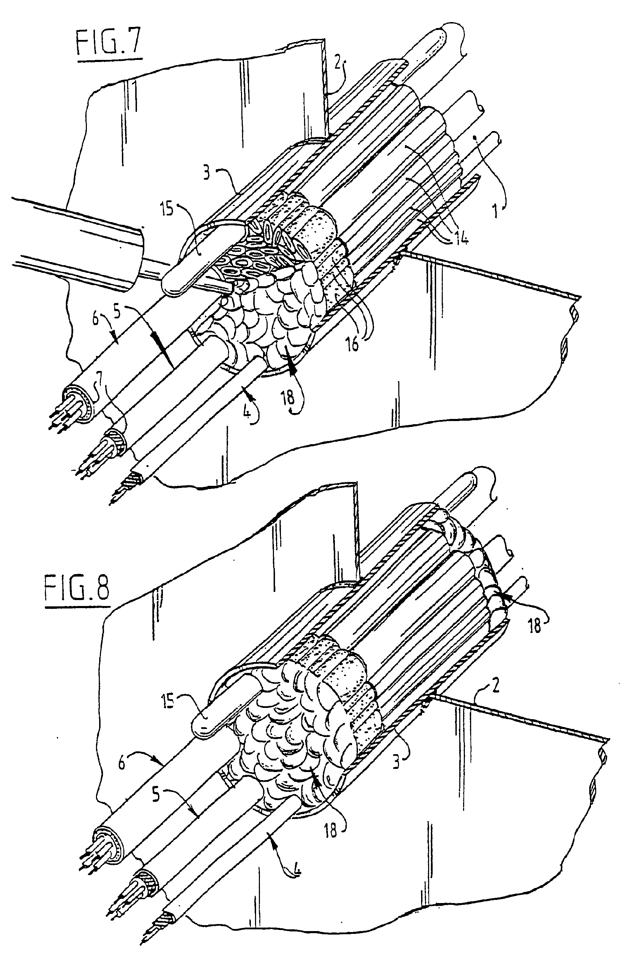

In Figure 5, hose members 16 of an electrically conductive material are disposed on one open side of wall opening 1, whilst it is also possible to use folded pieces 17 of tape 10 (Figure 6) in addition to or instead of said hose members. Since the hose members 16 are made of the same electrically conductive material as tape 10, viz. EPDM rubber that has been made electrically conductive by the addition of carbon particles, the electrically conductive cable shielding 8 is in earthed connection with steel bushing housing 3 via tape 10, hose members 16 and/or pieces of tape 17. As already said before, tape 10 is wound to a diameter larger than that of the cable so as to ensure the electrically conductive contact between tape 10 and hose members 16. Finally, a putty 18 which is known under the trade name "FIWA" of the present applicant is sealingly provided on that side of the wall opening 1 (Figure 7). It is also possible, of course, to fit the hose members 16 and/or the pieces of tape 17 on either side of the wall opening 1. In particular tape 10 and putty 18 provide an airtight seal of opening 1, thus preventing corrosion of the electrically conductive cable shielding 8.

The present bushing arrangement is based on the use of two types of hose members, therefore: hose members 11, 12, 13, 14 of a fire resistant (non-vulcanized) rubber on the one hand (with hose members 11, 12, 13 being fitted around cables 4, 5 and 6, respectively, and hose members 14 functioning as fillers), and hose members 16 of an electrically conductive rubber material corresponding to that of tape 10 on the other hand. It is also possible, of course, to form both types of hose members of said electrically conductive rubber. In addition, it is possible to use massive hose members 14, 16 of vulcanized rubber instead of or in addition to the hollow hose members 14, 16. Such massive hose members in fact form bar material in that case.

From the figures it will be understood that the terms opening in the wall, wall opening or the like as used herein, when used in conjunction with a bushing arrangement, are understood to mean the opening in the bushing housing, the bushing housing opening and the like.

It is noted that the invention is not restricted to the embodiment as shown in the drawing, but that it also comprises other embodiments that fall within the scope of the appended claims.

## Claims

1. A bushing arrangement for passing at least one cable (4, 5, 6) through an opening in a wall (2) and the like whilst providing protection against electromagnetic overtension and/or interference, **characterized in that** said bushing arrangement comprises an electrically conductive tape (10), which is in contact with an electrically conductive cable shielding (8) of said at least one cable (4, 5, 6) being passed through and which functions to earth said cable shielding (8), wherein said electrically conductive tape (10) is substantially made of an electrically conductive rubber being made electrically conductive through the addition thereto of carbon particles in the form of carbon black.

2. A bushing arrangement according to claim 1, wherein said electrically conductive tape (10) is at least partially wound round the electrically conductive cable shielding (8) in the operative condition.

3. A bushing arrangement according to claim 1 or 2, wherein said electrically conductive tape (10) is wound round the electrically conductive cable shielding (8) near its one end, whilst it is in electrically conductive contact with an electrically conductive bushing housing that is fitted in the opening in the wall (2).

4. A bushing arrangement according to claim 1, 2 or 3, wherein an electrically conductive material is provided on at least one open side of the wall (2), which material is in electrically conductive contact with the tape (10).

5. A bushing arrangement according to claim 4, wherein said electrically conductive material is at least substantially made up of several pieces (17) of electrically conductive tape material (10), whether or not folded, which have been placed into said opening.

6. A bushing arrangement according to claim 4 or 5, wherein said electrically conductive material is at least substantially made up of several electrically conductive sleeve means (10) which have been placed into said opening.

7. A bushing arrangement according to any one of the preceding claims 1 - 6, wherein said electrically conductive material is substantially made of an electrically conductive rubber.

8. A bushing arrangement according to claim 7, wherein said rubber has been made electrically conductive through the addition thereto of carbon particles, preferably in the form of carbon black.

9. A bushing arrangement according to any one of the preceding claims 1 - 8, wherein said carbon particles are concave, shell-shaped particles.

10. A bushing arrangement according to any one of the preceding claims 1 - 9, wherein said rubber is EPDM rubber.

11. A bushing arrangement according to any one of the preceding claims 1 - 10, wherein said electrically conductive tape (10) has a contact width of at least about 20 mm, preferably about 40 mm.

12. A bushing arrangement according to any one of the preceding claims 1 - 11, wherein the remaining space in the wall opening is at least partially filled up with several fire resistant sleeve means (14), which extend in the same direction as said at least one cable (4, 5, 6) being passed through.

13. A bushing arrangement according to claim 12, wherein said at least one cable (4, 5, 6) is passed through a fire resistant sleeve member (11, 12, 13).

14. A bushing arrangement according to any one of the preceding claims 1 - 13, wherein a heat resistant and/or liquid repellent putty (18) is sealingly provided on at least one open side of the opening.

15. A method for passing at least one cable (4, 5, 6) through an opening in a wall (2) and the like whilst providing protection against electromagnetic overtension and/or interference, wherein the method comprises
- using a bushing arrangement for passing the at least one cable through the opening in the wall (2) and the like,
- passing the at least one cable (4, 5, 6) through the opening in the wall (2) and the like,
- bringing an electrically conductive tape (10) into contact with the electrically conductive shielding (8) of said at least one cable (4, 5, 6) being passed through for the purpose of earthing it.

## Patentansprüche

1. Durchführungsvorrichtung zum Hindurchführen zumindest eines Kabels (4, 5, 6) durch eine Öffnung in einer Wand (2) und ähnlichem unter Bereitstellung eines Schutzes gegen elektromagnetische Überspannung und/oder Interferenz, charakterisiert **dadurch**, dass die Durchführungseinrichtung ein elektrisch leitendes Band (10) umfasst, das in Kontakt mit einer elektrisch leitenden Kabelschirmung (8) des zumindest einen hindurch geführten Kabels (4, 5, 6) steht und welches dazu dient, die Kabelschirmung (8) zu erden, wobei das elektrisch leitende Band (10) im Wesentlichen aus einem elektrisch leitenden Gummi hergestellt ist, das durch das Hinzufügen zu ihm von Kohlenstoffpartikeln in Form von Ruß elektrisch leitend gemacht ist.

2. Durchführungsvorrichtung gemäß Anspruch 1, wobei das elektrisch leitende Band (10) im Betriebszustand zumindest teilweise um die elektrisch leitende Kabelschirmung (8) herum gewickelt ist.

3. Durchführungsvorrichtung gemäß Anspruch 1 oder 2, wobei das elektrisch leitende Band (10) um die elektrisch leitende Kabelschirmung in der Nähe ihres einen Endes herumgewickelt ist, wobei es in elektrisch leitendem Kontakt mit einem elektrisch leitenden Durchführungsgehäuse steht, das in die Öffnung in der Wand (2) eingepasst ist.

4. Durchführungsvorrichtung gemäß Anspruch 1, 2 oder 3, wobei ein elektrisch leitendes Material an zumindest einer offenen Seite der Wand (2) vorgesehen ist, wobei das Material in elektrisch leitendem Kontakt mit dem Band (10) steht.

5. Durchführungsvorrichtung gemäß Anspruch 4, wobei das elektrisch leitende Material zumindest im Wesentlichen aus einigen Teilen (17) elektrisch leitenden Bandmaterials (10) zusammengesetzt ist, gefaltet oder nicht gefaltet, die in die Öffnung hereingesetzt wurden.

6. Durchführungsvorrichtung gemäß Anspruch 4 oder 5, wobei das elektrisch leitende Material zumindest im Wesentlichen aus mehreren elektrisch leitenden Manschettenmitteln (10) zusammengesetzt ist, die in die Öffnung hereingesetzt sind.

7. Durchführungsvorrichtung gemäß einem der vorstehenden Ansprüche 1 bis 6, wobei das elektrisch leitende Material im Wesentlichen aus einem elektrisch leitenden Gummi hergestellt ist.

8. Durchführungsvorrichtung gemäß Anspruch 7, wobei das Gummi im Wesentlichen elektrisch leitend gemacht wurde durch das Hinzufügen von Kohlenstoffpartikeln, bevorzugt in der Form von Ruß.

9. Durchführungsvorrichtung gemäß einem der vorstehenden Ansprüche 1 bis 8, wobei die Kohlenstoffpartikel konkave, muschelförmige Partikel sind.

10. Durchführungsvorrichtung gemäß einem der vorstehenden Ansprüche 1 bis 9, wobei das Gummi ein EPDM Gummi ist.

11. Durchführungsvorrichtung gemäß einem der vorstehenden Ansprüche 1 bis 10, wobei das elektrisch leitende Band (10) eine Kontaktbreite von zumindest ungefähr 20 mm, bevorzugt ungefähr 40 mm, aufweist.

12. Durchführungsvorrichtung gemäß einem der vorstehenden Ansprüche 1 bis 11, wobei der übrig bleibende Raum in der Wandöffnung zumindest teilweise mit einigen Feuer resistenten Manschettenmitteln (14) ausgefüllt ist, die sich in die gleiche Richtung erstrecken, wie das zumindest eine, hindurch geführte Kabel (4, 5, 6).

13. Durchführungsvorrichtung gemäß Anspruch 12, wobei das zumindest eine Kabel (4, 5, 6) durch ein Feuer resistentes Manschettenmittel (11, 12, 13) hindurch geführt ist.

14. Durchführungsvorrichtung gemäß einem der vorstehenden Ansprüche 1 bis 13, wobei ein wärmeresistenter und/oder flüssigkeitsabstoßender Kitt (18) abdichtend an zumindest einer offenen Seite der Öffnung vorgesehen ist.

15. Verfahren zum Hindurchführen zumindest eines Kabels (4, 5, 6) durch eine Öffnung einer Wand (2) und ähnlichem unter Bereitstellung eines Schutzes gegen elektromagnetische Überspannung und/oder Interferenz, wobei das Verfahren umfasst:
- Verwenden einer Durchführungsvorrichtung zum Hindurchführen des zumindest einen Kabels durch die Öffnung in der Wand (2) und ähnlichem,
- Hindurchführen des zumindest einen Kabels (4, 5, 6) durch die Öffnung in der Wand (2) und ähnlichem,
- in Kontakt bringen eines elektrisch leitenden Bandes (10) mit der elektrisch leitenden Abschirmung (8) des zumindest einen, hindurch geführten Kabels (4, 5, 6), um es zu erden.

## Revendications

1. Agencement de gaine pour le passage d'au moins un câble (4, 5, 6) à travers une ouverture dans un mur (2) et analogue, tout en assurant une protection contre la surtension et/ou l'interférence électromagnétique, **caractérisé en ce que** ledit agencement de gaine comprend un ruban électriquement conducteur (10) qui est en contact avec un blindage de câble électriquement conducteur (8) dudit au moins un câble (4, 5, 6) étant passé à travers l'ouverture et dont la fonction est de mettre à la terre ledit blindage de câble (8), dans lequel ledit ruban électriquement conducteur (10) est essentiellement réalisé à partir d'un caoutchouc électriquement conducteur qui est rendu électriquement conducteur par addition de particules de carbone sous forme de noir de carbone.

2. Agencement de gaine selon la revendication 1, dans lequel ledit ruban électriquement conducteur (10) est au moins partiellement enroulé autour du blindage de câble électriquement conducteur (8) dans la condition de fonctionnement.

3. Agencement de gaine selon la revendication 1 ou 2, dans lequel ledit ruban électriquement conducteur (10) est enroulé autour du blindage de câble électriquement conducteur (8) à proximité de l'une de ses extrémités, tandis qu'il est en contact électriquement conducteur avec un logement de gaine électriquement conducteur qui est monté dans l'ouverture du mur (2).

4. Agencement de gaine selon la revendication 1, 2 ou 3, dans lequel un matériau électriquement conducteur est prévu sur au moins un côté ouvert du mur (2), lequel matériau est en contact électriquement conducteur avec le ruban (10).

5. Agencement de gaine selon la revendication 4, dans lequel ledit matériau électriquement conducteur est au moins essentiellement réalisé à partir de plusieurs pièces (17) d'un matériau de ruban électriquement conducteur (10), plié ou non plié, qui a été mis en place dans ladite ouverture.

6. Agencement de gaine selon la revendication 4 ou 5, dans lequel ledit matériau électriquement conducteur est au moins essentiellement réalisé à partir de plusieurs moyens de manchons électriquement conducteurs (10) qui ont été placés dans ladite ouverture.

7. Agencement de gaine selon l'une quelconque des revendications précédentes 1 à 6, dans lequel ledit matériau électriquement conducteur est essentiellement réalisé à partir d'un caoutchouc électriquement conducteur.

8. Agencement de gaine selon la revendication 7, dans lequel ledit caoutchouc a été rendu électriquement conducteur par addition de particules de carbone, de préférence sous forme de noir de carbone.

9. Agencement de gaine selon l'une quelconque des revendications précédentes 1 à 8, dans lequel lesdites particules de carbone sont des particules concaves, en forme de coquilles.

10. Agencement de gaine selon l'une quelconque des revendications précédentes 1 à 9, dans lequel ledit caoutchouc est du caoutchouc EPDM.

11. Agencement de gaine selon l'une quelconque des revendications précédentes 1 à 10, dans lequel ledit ruban électriquement conducteur (10) présente une largeur de contact d'au moins environ 20 mm, de préférence environ 40 mm.

12. Agencement de gaine selon l'une quelconque des revendications précédentes 1 à 11, dans lequel l'espace restant dans l'ouverture de mur est au moins partiellement rempli de plusieurs moyens de manchons ignifuges (14) qui s'étendent dans la même direction que ledit au moins un câble (4, 5, 6) qui le traverse.

13. Agencement de gaine selon la revendication 12, dans lequel ledit au moins un câble (4, 5, 6) est amené à travers un élément de manchon ignifuge (11, 12, 13).

14. Agencement de gaine selon l'une quelconque des revendications précédentes 1 à 13, dans lequel un mastic résistant à la chaleur et/ou hydrophobe (18) est disposé de façon étanche sur au moins un côté ouvert de l'ouverture.

15. Procédé pour faire passer au moins un câble (4, 5, 6) à travers une ouverture dans un mur (2) et analogue, tout en assurant une protection contre la surtension et/ou l'interférence électromagnétique, dans lequel le procédé comprend
- l'utilisation d'un agencement de gaine pour le passage d'au moins un câble à travers l'ouverture dans le mur (2) et analogue,
- le passage d'au moins un câble (4, 5, 6) à travers l'ouverture dans le mur (2) et analogue,
- la mise en contact d'un ruban électriquement conducteur (10) avec le blindage électriquement conducteur (8) dudit au moins un câble (4, 5, 6) que l'on fait traverser afin de le mettre à la terre.
